# EUROPÄISCHE PATENTSCHRIFT

(11) **EP 3 477 802 B1**
(45) Veröffentlichungstag und Bekanntmachung des Hinweises auf die Patenterteilung: **12.01.2022**
(21) Anmeldenummer: 17198430.5
(22) Anmeldetag: 26.10.2017
(51) Int. Cl.: H02B 1/30, H02B 1/38, H02B 3/00

(54) **STABILISIERUNGSANORDNUNG FÜR DEN TRANSPORT EINES SCHALTSCHRANKS**
STABILISATION ASSEMBLY FOR THE TRANSPORT OF A CONTROL CABINET
DISPOSITIF DE STABILISATION POUR LE TRANSPORT D'UNE ARMOIRE DE COMMANDE

(43) Veröffentlichungstag der Anmeldung: 01.05.2019
(73) Patentinhaber: Rittal GmbH & Co. KG, 35745 Herborn (DE)
(72) Erfinder: Clements, Paul, PL7 2SU Plymouth (GB); Sillingford, Malcolm, PL4 8PX Plymouth (GB)
(74) Vertreter: Angerhausen, Christoph

(56) Entgegenhaltungen:
- DE-C1- 10 202 845
- DE-C1- 19 939 614
- US-A1- 2011 260 591
- US-A1- 2014 097 734

## Beschreibung

Die Erfindung geht aus von einer Stabilisierungsanordnung für den Transport eines Schaltschranks, mit einem Schaltschrank, der ein Rahmengestell aus Vertikal- und Horizontalstreben aufweist, und mit einer an einer Türseite des Rahmengestells über mindestens ein Scharnier befestigten Schaltschranktür, so dass die Schaltschranktür zwischen einer Offenposition, in der sie von der Türseite abgeschwenkt ist, und einer Schließposition, in der sie an der Türseite anliegt, hin und her schwenkbar ist. Aus der CN 204425828 U ist Stabilisierungsanordnung bekannt, bei der das Schaltschrankrahmengestell durch eine Versteifungsstruktur zusätzlich verstärkt ist. Ähnliche Anordnungen zeigen auch die DE 102 02 845 C1 und die DE 196 15 430 C1. Weitere Stabilisierungsanordnungen sind auch in der DE 199 39 614 C1 und in der US 2014/097734 A1 beschrieben.

Die aus dem Stand der Technik bekannten Stabilisierungsanordnungen haben den Nachteil, dass sie konstruktiv aufwendig gestaltet sind und zum Teil einen erheblichen Materialaufwand bedingen. So ist bei der CN 204425828 U beispielsweise vorgesehen, dass die Rückwand des Schrankschranks doppelwandig ausgebildet ist, um dem Schaltschrank Stabilität zu verleihen.

Es ist daher die Aufgabe der Erfindung, eine Stabilisierungsanordnung der eingangs beschriebenen Art derart weiterzuentwickeln, dass sie mit technisch einfachen Mitteln und damit kostengünstig zur Verfügung gestellt werden kann. Die Stabilisierungsanordnung sollte weiterhin derart ausgestaltet sein, dass die zur Stabilisierung vorgesehenen Mittel nach dem Transport, das heißt nachdem das Schaltschrankgehäuse seine endgültige Position erreicht hat, leicht entfernt werden können.

Diese Aufgabe wird durch eine Stabilisierungsanordnung mit den Merkmalen des Anspruchs 1 gelöst. Die abhängigen Ansprüche betreffen jeweils vorteilhafte Ausführungsformen der Erfindung.

Demgemäß ist vorgesehen, dass an der Türseite mindestens ein Formschlussstück befestigt ist, das sich mit seinem freien Ende von der Türseite weg erstreckt und an seinem freien Ende einen Hinterschnitt aufweist, wobei die Schaltschranktür, vorzugsweise an ihrer in der Schließstellung der Türseite zugewandten Innenseite, eine Formschlussaufnahme aufweist, in die in der Schließstellung das Formschlussstück mit seinem freien Ende hineinragt und die von dem Hinterschnitt in der Schließstellung hintergriffen ist, und wobei das mindestens eine Formschlussstück lösbar an der Türseite befestigt ist und derart ausgestaltet ist, dass es nach dem Transport, das heißt nachdem der Schaltschrank seine endgültige Position erreicht hat, wieder entfernt wird.

Bei der beschriebenen Stabilisierungsanordnung wird somit die Schaltschranktür während des Transports des Schaltschranks über das in die Formschlussaufnahme der Schaltschranktür eingreifende Formschlussstück des Rahmengestells gegenüber dem Rahmengestell stabilisiert, so dass die Schaltschranktür im Transportfall die Zusatzfunktion aufweist, das Rahmengestell in sich zu stabilisieren. Die Stabilisierung kann verbessert werden, indem mehrere Paare aus einer Formschlussaufnahme und einem darin eingreifenden Formschlussstück vorgesehen sind, beispielsweise diametral gegenüber liegend. Funktional betrachtet hat die Schaltschranktür bei diametral gegenüber liegenden Paaren aus einer Formschlussaufnahme und einem darin eingreifenden Formschlussstück die Wirkung einer sich in der Türseite quer erstreckenden Versteifungsstrebe.

Die Formschlussstücke können als einteilige oder mehrteilige Kunststoff- oder Metallformteile ausgebildet sein, die mit dem Rahmengestell des Schaltschranks über die Türseite des Rahmengestells bedarfsweise verschraubt oder anderweitig lösbar verbunden werden können. Dazu kann beispielsweise vorgesehen sein, dass die Formschlussstücke über die in gängigen Rahmengestellen ohnehin vorhandene Systemlochung aus regelmäßig beabstandeten Befestigungsaufnahmen festgelegt werden. Dazu kann beispielsweise in einer der Befestigungsaufnahmen eine Einsteckmutter mit einem Innengewinde angeordnet werden, während das Formschlussstück einen Gewindebolzen aufweist, mit dem es in die Einsteckmutter eingeschraubt und damit an dem Rahmengestell festgelegt wird.

Das freie Ende des Formschlussstücks kann in Richtung senkrecht zur Erstreckungsrichtung des Formschlussstücks eine maximale Abmessung aufweisen, die einer Innenabmessung der Formschlussaufnahme entspricht. Das freie Ende kann weiterhin eine Anlaufkontur aufweisen, entlang welcher sich das Formschlussstück von seiner Stirnseite auf die maximale Abmessung aufweitet. Beim Zuschwenken der Schaltschranktür wird somit auch dann eine sichere Einführung des freien Endes in die Formschlussaufnahme der Schaltschranktür gewährleistet, wenn beispielsweise aufgrund von Fertigungstoleranzen bei dem Aufeinandertreffen von Formschlussaufnahme und Formschlussstück die beiden nicht exakt fluchten.

Das freie Ende kann in Erstreckungsrichtung des Formschlussstücks an dem Hinterschnitt in einen Schacht des Formschlussstücks übergehen, über den das Formschlussstück an der Türseite festgelegt ist. Der Schaft kann in Richtung senkrecht zur Erstreckungsrichtung des Formschlussstücks eine maximale Abmessung aufweisen, die kleiner als eine Innenabmessung der Formschlussaufnahme ist. Es ist insbesondere nicht erforderlich, dass der Schaft formschlüssig in der Formschlussaufnahme aufgenommen ist. Die Funktion der Stabilisierungsanordnung kann bereits dadurch erfüllt sein, dass beispielsweise während des Transportes des Schaltschranks auftretende Verwindungen des Schaltschrankrahmengestells auf ein bestimmtes (geringes) maximal zugelassenes Maß beschränkt werden.

Die Formschlussaufnahme kann ein Durchbruch in einer U-Umkantung am Außenumfang der Schaltschranktür sein. Die U-Umkantung kann insbesondere eine Umkantung am Außenumfang des Türblatts der Schaltschranktür sein. Dabei kann das Türblatt zur Türinnenseite U-förmig umgekantet sein. In der Schließstellung kann somit das freie Ende zwischen den beiden parallel zueinander beabstandeten Flanschen der U-Umkantung aufgenommen sein.

Das Formschlussstück kann einen Korpus und ein Befestigungsmittel aufweisen, das den Korpus an der Türseite unbeweglich festlegt. Der Korpus weist das freie Ende und einen daran über den Hinterschnitt angrenzenden Schaft auf, über den das Formschlussstück an die Türseite angrenzt, insbesondere an dem Rahmengestell anliegt.

Der Korpus und das Befestigungsmittel können als separate Bauteile ausgebildet sein. Dabei kann der Korpus eine Durchgangsbohrung aufweisen, über die der Korpus mit dem Befestigungsmittel, insbesondere mit einem Schraubbolzen, an der Türseite festgelegt ist.

Die Durchgangsbohrung kann sich dabei exzentrisch und parallel zu einer Symmetrieachse des Korpus durch den Korpus erstrecken, wobei der Schaft an seinem der Türseite zugewandten Ende einen Vorsprung aufweist, der ebenfalls exzentrisch zu der Symmetrieachse des Korpus, jedoch in Bezug auf die Symmetrieachse gegenüber der Durchgangsbohrung angeordnet ist, und wobei der Schaft mit dem Vorsprung auf einer horizontalen Auflage des Rahmengestells aufliegt.

Der Korpus und das Befestigungsmittel können auch einteilig ausgebildet sein, wobei sich das Befestigungsmittel, insbesondere ein Schraubbolzen, konzentrisch zu dem Schaft erstreckt und an ein der Türseite zugewandtes Ende des Schafts angeformt ist.

Die Türseite kann einen rechteckigen Profilrahmen aufweisen, wobei an dem Profilrahmen zwei der Formschlussstücke diametral gegenüberliegend angeordnet sind.

Dabei können an dem Profilrahmen zwei Paare Formschlussstücke angeordnet sein, von denen die beiden Formschlusstücke eines ersten der Paare und die beiden Formschlussstücke eines zweiten der Paare jeweils diametral gegenüberliegend, insbesondere in diametral gegenüberliegenden Eckbereichen des Profilrahmens, angeordnet sind.

Das Rahmengestell kann einen rechteckigen Bodenrahmen aus vier Horizontalstreben aufweisen, von denen eine Horizontalstrebe in der Türseite liegt und an dieser Horizontalstrebe mindestens ein Haltewinkel über einen Befestigungsflansch des Haltewinkels montiert ist, der in der Türseite liegt, wobei an dem Befestigungsflansch das mindestens eine Formschlussstück festgelegt ist, und vorzugsweise der Befestigungsflansch über einen Gewindebolzen des Formschlussstücks an der Horizontalstrebe festgelegt ist.

Der Schaltschrank kann über den mindestens einen Haltewinkel an mindestens einem Gleitboard unterhalb des Bodenrahmens befestigt sein, wobei der Bodenrahmen über den mindestens einen Haltewinkel unter einem Abstand zu dem mindestens einen Gleitboard auf einer mit einem Gabelstapler unterfahrbaren Transportpalette aufsteht.

Der Bodenrahmen kann an jeder seiner vier Ecken einen als L-Winkel ausgebildeten Haltewinkel aufweisen, über den der Schaltschrank an einem Gleitboard befestigt ist, wobei der Abstand, unter dem der Bodenrahmen zu dem mindestens einen Gleitboard an dem Gleitboard befestigt ist, einer vertikalen Abmessung eines Schaltschranksockels entspricht, und wobei die Haltewinkel an einer Vertikalseite des Bodenrahmens und sich mit ihrem Aufstandsflansch von dem Schaltschrank weg erstreckend befestigt sind, so dass eine Aufstandsseite des Bodenrahmens für die Montage eines Schaltschranksockels an der Aufstandsseite vollständig freiliegt. Entsprechende Haltewinkel können an einer weiteren Horizontalstrebe des Bodenrahmens befestigt sein, die der Horizontalstrebe, die in der Türseite liegt, gegenüber angeordnet ist, insbesondere in einer Rückwandseite des Rahmengestells.

Die Transportpalette kann eine Einfassung aufweisen, die das mindestens eine Gleitboard umrandet, so dass der Schaltschrank auf der Transportpalette in Horizontalrichtung bzw. bei gekippter Palette in der Ebene einer Aufstandsfläche der Palette unverrückbar ist.

Weitere Einzelheiten der Erfindung werden anhand der nachstehenden Figuren erläutert. Dabei zeigt:
- Figur 1: in perspektivischer Darstellung eine beispielshafte Ausführungsform einer Stabilisierungsanordnung;
- Figur 2: in perspektivischer Darstellung den Eckbereich eines Schaltschranks einer Stabilisierungsanordnung gemäß einer Ausführungsform in einer Explosionsdarstellung des Formschlussstücks;
- Figur 3: die Ausführungsform und Ansicht gemäß Figur 2, wobei das Formschlussstück in der vollständig montierten Position gezeigt ist;
- Figur 4: in perspektivischer Darstellung den Eckbereich einer weiteren Ausführungsform der Erfindung, wobei das Formschlussstück in einer von dem Schaltschrank demontierten Stellung gezeigt ist;
- Figur 5: die Ausführungsform und Ansicht gemäß Figur 4, wobei das Formschlussstück an dem Schaltschrankrahmen montiert ist;
- Figur 6: eine Seitenansicht des Eckbereichs einer Ausführungsform einer erfindungsgemäßen Stabilisierungsanordnung im Dachbereich des Schaltschranks;
- Figur 7: die Ausführungsform gemäß Figur 6, wobei der Eckbereich des Bodenrahmens des Schaltschranks gezeigt ist;
- Figur 8: eine erste Ausführungsform eines Formschlussstücks;
- Figur 9: eine Querschnittsansicht des Korpus der Ausführungsform gemäß Figur 8;
- Figur 10: in perspektivischer Darstellung eine weitere Ausführungsform eines Formschlussstücks;
- Figur 11: eine Querschnittsansicht der Ausführungsform gemäß Figur 10; und
- Figur 12: eine beispielhafte Transportsituation unter Verwendung einer erfindungsgemäßen Stabilisierungsanordnung.

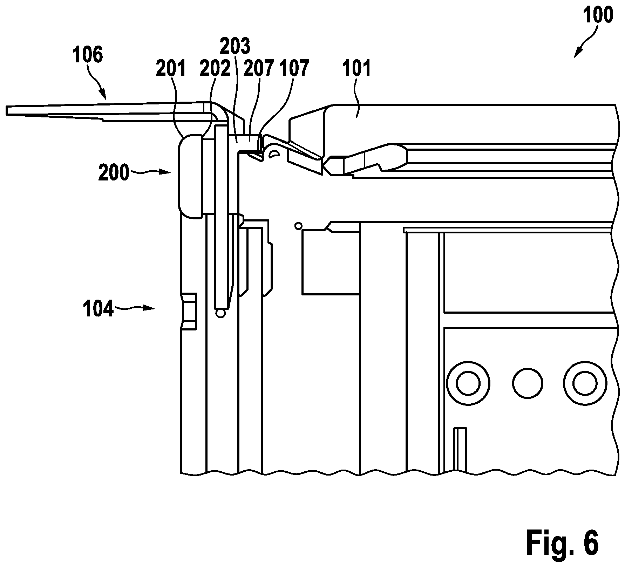

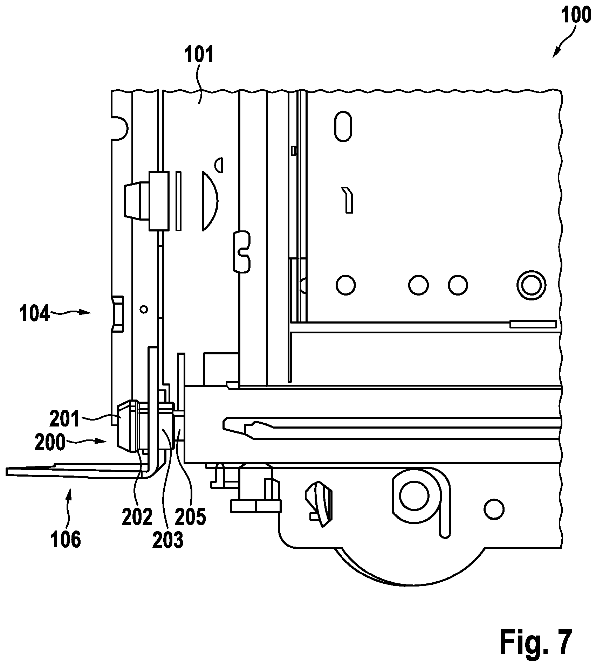

Die Figur 1 zeigt eine beispielhafte Ausführungsform einer Stabilisierungsanordnung für den Transport eines Schaltschranks 100. Der Schaltschrank 100 weist ein Rahmengestell 101 aus Vertikal- und Horizontalstreben auf, wobei an einer Türseite 102 des Rahmengestells 101 über drei Scharniere 103 eine Schaltschranktür 104 befestigt ist. Die Schaltschranktür 104 ist so zwischen einer Offenposition, in der sie von der Türseite 102 abgeschwenkt ist (wie dargestellt), und einer Schließposition, in der sie an der Türseite 102 anliegt (vergleiche Figuren 6 und 7), hin und her schwenkbar.

An der Türseite 102 sind vier Formschlussstücke 200 befestigt, die sich mit ihren freien Enden 201 von der Türseite 102 weg erstrecken. Die Formschlussstücke 200 sind dazu insbesondere an einer vertikalen Profilseite der Horizontalstreben der Türseite 102 befestigt, beispielsweise über eine Systemlochung aus regelmäßig beabstandeten Befestigungsaufnahmen mit der Profilseite verschraubt. Insbesondere ist jeweils ein Formschlussstück 200 in einer der vier Ecken der Türseite 102, beziehungsweise entlang der Horizontalprofile der Türseite 102 ihrer jeweiligen Ecke vorgelagert angeordnet.

Das Rahmengestell 101 weist weiterhin einen rechteckigen Bodenrahmen 109 aus vier Horizontalstreben auf. Eine der Horizontalstreben, nämlich die mit dem Bezugszeichen 110 gekennzeichnete Horizontalstrebe ist in der Türseite 102 angeordnet. Eine der in der Türseite 102 angeordneten Horizontalstrebe 110 gegenüberliegende weitere Horizontalstrebe des Bodenrahmens 109 ist in der Rückwandseite des Rahmengestells 101 angeordnet. Über die Horizontalstreben 110 in der Türseite 102 und in der Rückwandseite sind jeweils zwei Haltewinkel 111 über einen Befestigungsflansch 112 befestigt, der in der Türseite 102 liegt. An jedem der beiden Haltewinkel 111, insbesondere an dem jeweiligen Befestigungsflansch 112, ist eines der Formschlussstücke 200 befestigt. Über die Haltewinkel 111 ist der Schaltschrank 100 an zwei Gleitboards 300 unterhalb des Bodenrahmens 109 befestigt. Insbesondere ist der Bodenrahmen 109 über die vier Haltewinkel 111 unter einem Abstand zu den Gleitboards 300 auf einer mit einem Gabelstapler unterfahrbaren Transportpalette 400 aufgesetzt.

Insbesondere weist der Bodenrahmen an jeder seiner vier Ecken als L-Winkel ausgebildete Haltewinkel 111 auf, über die der Schaltschrank an einem von vier Gleitboards befestigt ist. Der Abstand, unter dem der Bodenrahmen 109 zu den Gleitboards 300 befestigt ist, entspricht einer vertikalen Abmessung eines Schaltschranksockels. Die Haltewinkel 111 sind an einer Vertikalseite des Bodenrahmens 109 und sich mit ihrem Aufstandsflansch 113 von dem Schaltschrank 100 weg erstreckend befestigt, so dass eine Aufstandsseite des Bodenrahmens 109 für die Montage eines Schaltschranksockels an der Aufstandsseite vollständig freiliegt.

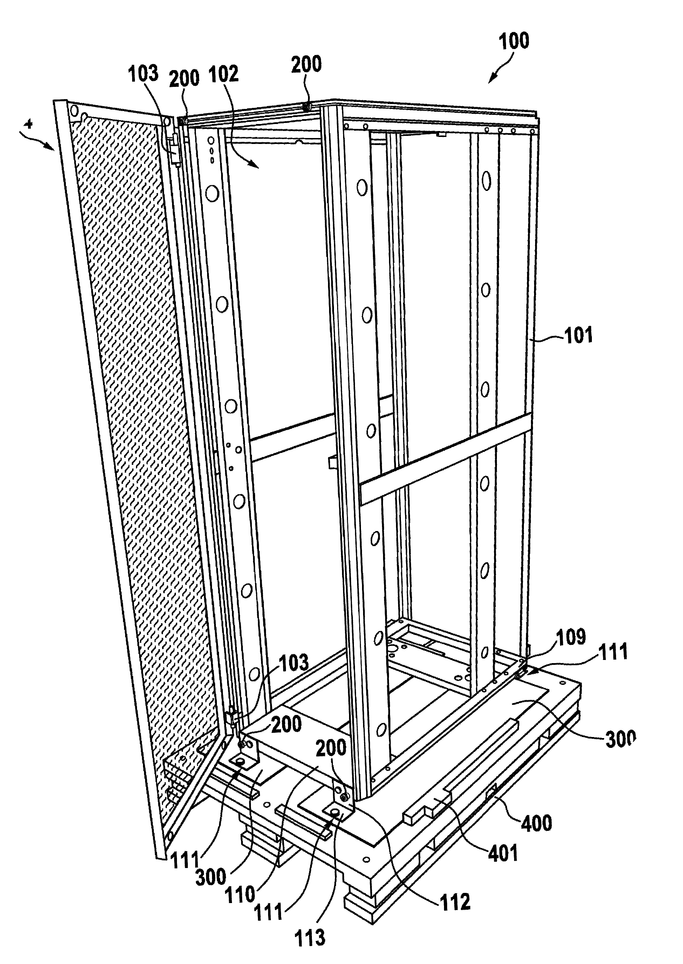

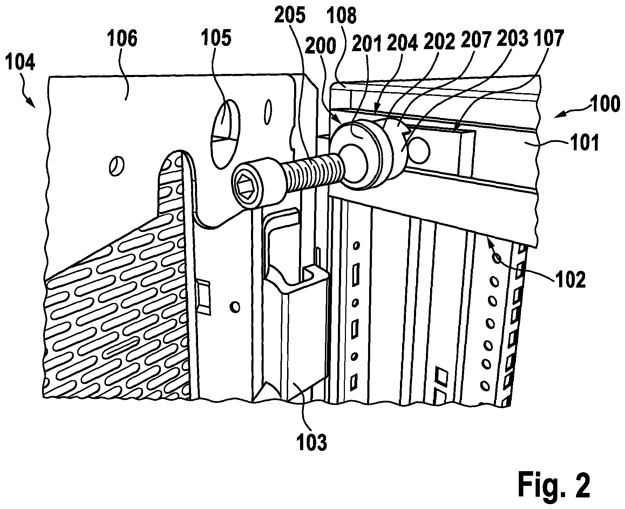

Die Transportpalette 400 weist eine Einfassung 401 auf, die die Gleitboards 300 umrandet und somit den Schaltschrank 100 auf der Transportpalette 400 in der Horizontalrichtung beziehungsweise in der Ebene der Aufstandsfläche der Transportpalette 400 bei gekippter Palette unverrückbar hält. Wie in Figur 2 gezeigt ist, ermöglicht dies insbesondere für den Transport des Schaltschranks mit einem Gabelstapler 500, dass der Schaltschrank mit seinen üblichen Einbauten (Montageplatte, usw.) bis zu einer Kantenhöhe von ungefähr 20 cm geneigt werden kann, ohne dadurch auf der Transportpalette 400 zu verrücken. Aufgrund der in die Formschlussaufnahmen 105 eingreifenden Formschlussstücke 200, kann in der Schließstellung der Schaltschranktür 104 einer Verwindung des Rahmengestells 101 beim Verkippen des Schaltschranks 100 entgegengewirkt werden.

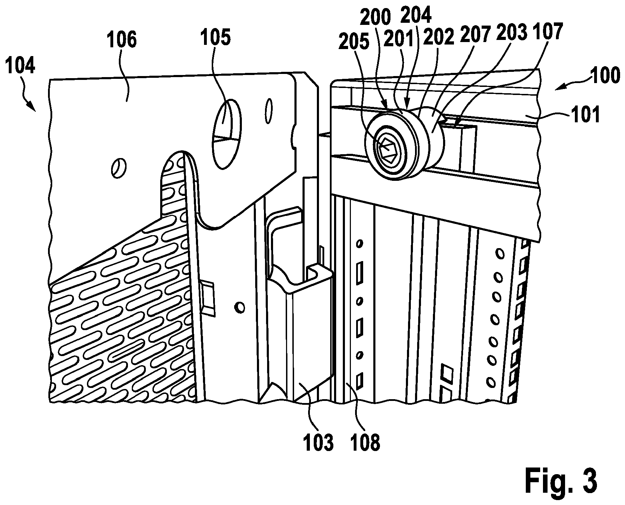

In den Figuren 2 und 3 ist ein erstes Formschlussstück 200 in einer Einbausituation am Dachrahmen eines Schaltschranks 100 dargestellt. Die Profilstreben des Dachrahmens weisen eine in der Schließstellung der Schaltschranktür 104 der Schaltschranktür 104 zugewandte Auflage 107 auf, auf der das Formschlussstück 200 mit einem Vorsprung 207 aufliegt und somit in der Vertikalrichtung gegenüber dem Rahmengestell 101 ausgerichtet ist.

Die Schaltschranktür 104 weist an ihrem Außenumfang eine U-Umkantung 106 auf, die von dem Türblatt der Schaltschranktür 104 zur Innenseite der Schaltschranktür 104 umgekantet ist. In einem parallel beabstandet zu dem Türblatt angeordneten Flansch der U-Umkantung 106 ist eine Formschlussaufnahme 105 in Form eines kreisförmigen Durchbruchs ausgebildet, in welchen das Formschlussstück 200 mit seinem freien Ende 201 in der Schließstellung der Schaltschranktür 104 eingreift. Das freie Ende 201 geht über einen Hinterschnitt 202 in einen schaftförmigen Abschnitt 203 des Formschlussstücks 200 über. Der Vorsprung 207 erstreckt sich über eine Auflagefläche des Schafts 203 hinaus, über welche der Schaft 203 an einer vertikalen Profilseite des Rahmengestells 101, insbesondere des Dachrahmens, anliegt.

Das Formschlussstück 200 ist zweiteilig ausgeführt und weist neben einem das freie Ende 201, den Hinterschnitt 202 und den Schaft 203 aufweisenden Korpus 204 ein Befestigungsmittel 205 in Form eines Schraubbolzens auf, über den der Korpus 204 an dem Rahmengestell 101 verschraubt werden kann. Das Rahmengestell 101 kann dazu insbesondere eine Anordnung aus regelmäßig beabstandeten Befestigungsaufnahmen aufweisen. Für die Verschraubung kann in eine der Befestigungsaufnahmen beispielsweise eine Käfigmutter eingesetzt sein.

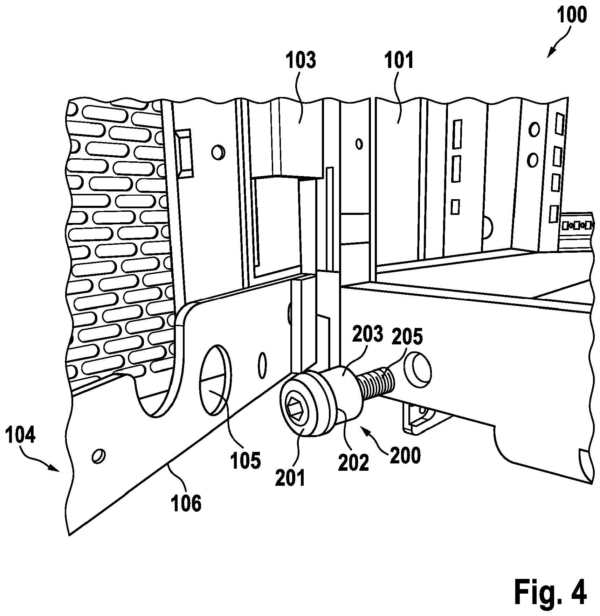

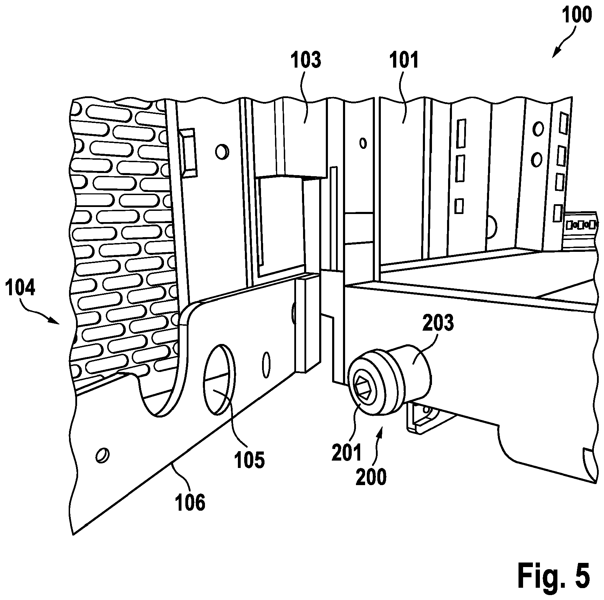

In den Figuren 4 und 5 ist eine weitere Ausführungsform eines Formsdilussstücks 200 gezeigt, welches im Bereich eines Bodenrahmens des Rahmengestells 101 im Eckbereich des Bodenrahmens verschraubt ist. Analog zu dem in den Figuren 3 und 4 gezeigten Formschlussstück 200 weist auch das Formschlussstück 200 gemäß den Figuren 4 und 5 ein freies Ende 201 mit einer Anlaufkontur auf, die über einen Hinterschnitt 202 in einen Schaft 203 übergeht. An dem dem freien Ende 201 gegenüberliegenden Ende des Schafts 203 ist konzentrisch zu dem Schaft 203 das Befestigungsmittel einteilig an den Schaft 203 angeformt und kann insbesondere nach Art eines Gewindebolzens ausgebildet sein.

Die Formschlussaufnahme 105 ist analog zu den in Figuren 3 und 4 gezeigten Formschlussaufnahmen wiederum als ein kreisförmiger Durchbruch in einer U-Umkantung 106 am Außenumfang einer Schaltschranktür 104 ausgebildet. Konzentrisch zu dem Gewindebolzen 205 weist das freie Ende 201 eine Werkzeugaufnahme auf, beispielsweise einen Innensechskant. Der Innensechskant kann identisch zu dem Innensechskant des Befestigungsmittels 205 der in den Figuren 2 und 3 gezeigten zweiteiligen Ausführungsform ausgebildet sein.

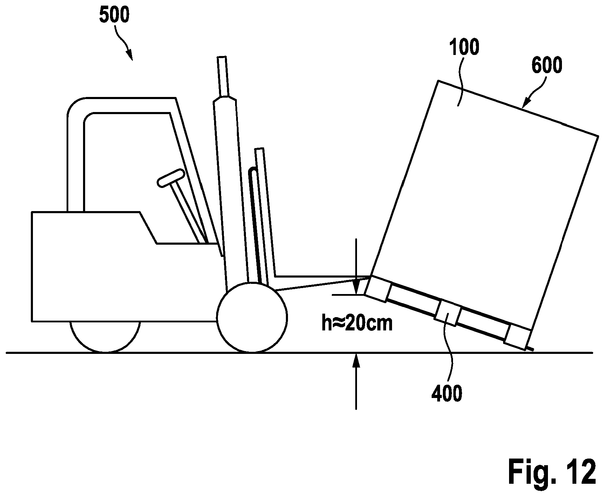

Die Figuren 6 und 7 zeigen jeweils einen Schaltschrank 100, bei dem die Schaltschranktür 104 in der geschlossenen Position angeordnet ist Während die Figur 6 den Schaltschrank 100 im Bereich des Dachrahmens zeigt, ist in der Figur 7 der Schaltschrank im Bereich des Bodenrahmens gezeigt. In der gezeigten Schließposition erstreckt sich das Formschlussstück 200 mit seinem freien Ende 201 durch einen vertikalen Flansch der U-Umkantung 106 hindurch, zumindest so weit, dass der vertikalen Flansch der U-Umkantung von dem Hinterschnitt 202 des Formschlussstücks hintergriffen ist. Im Bereich des Schaftes 203, mit welchem das Formschlussstück 200 durch den Flansch der U-Umkantung 106 hindurchragt, kann der Außendurchmesser des Formschlussstücks 200 geringer sein als der Innendurchmesser der Formschlussaufnahme 105 (vergleiche Figuren 2 bis 5), so dass die Stabilisierungsanordnung bei Belastung des Rahmengestells, etwa beim Verkippen des Schaltschranks, wie dies in Figur 12 gezeigt ist, eine gewisse maximale Verwindung des Rahmengestells 101 zulässt, bevor eine weitere Verbindung bei weiterer Belastung des Rahmengestells 101 aufgrund der in den Formschlussaufnahmen 105 aufgenommene Formschlussstücke 200 verhindert wird.

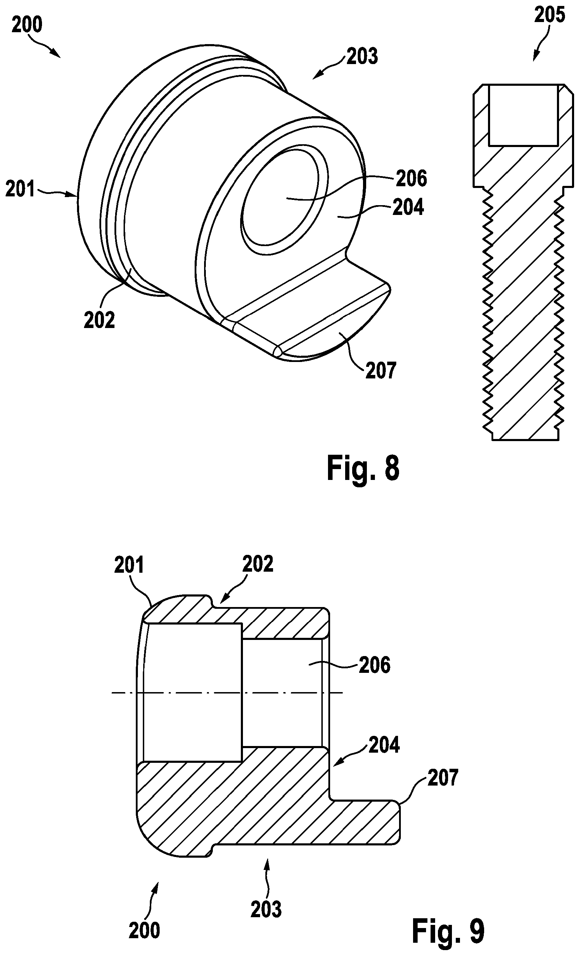

In den Figuren 8 und 9 ist eine erste Ausführungsform des Formschlussstücks 200 gezeigt. Das Formschlussstück 200 weist ein freies Ende 201, das über einen Hinterschnitt 202 in einen Schaft 203 übergeht. Das freie Ende 201, der Hinterschnitt 202 und der Schaft 203 bilden einen Korpus 204, der eine zur Symmetrieachse des Formschlussstücks 200 exzentrische Durchgangsbohrung 206 aufweist. Von einer der Stirnseite des freien Endes 201 gegenüber angeordneten Rückseite des Formschlussstücks, welche gleichzeitig eine Anlagefläche des Schaftes 203 bildet, über welche das Formschlussstück 200 an dem Rahmengestell eines Schaltschranks zur Anlage kommt, erstreckt sich ein Vorsprung 207 der, wie mit Bezug auf die in Figuren 2 und 3 gezeigte Ausführungsform auf einer entsprechenden horizontalen Auflage des Rahmengestells zur Anlage kommt, um das Formschlussstück 200 in der Vertikalausrichtung vorauszurichten. Ein Befestigungsmittel 205 in Form eines Gewindebolzens ist dazu vorgesehen, sich durch die Durchgangsbohrung 206 bis in ein Rahmengestell eines Schaltschranks hinein zu erstrecken, wo der Gewindebolzen 205 beispielsweise in eine Käfigmutter eingeschraubt sein kann und somit den Korpus 204 an dem Rahmengestell festlegt.

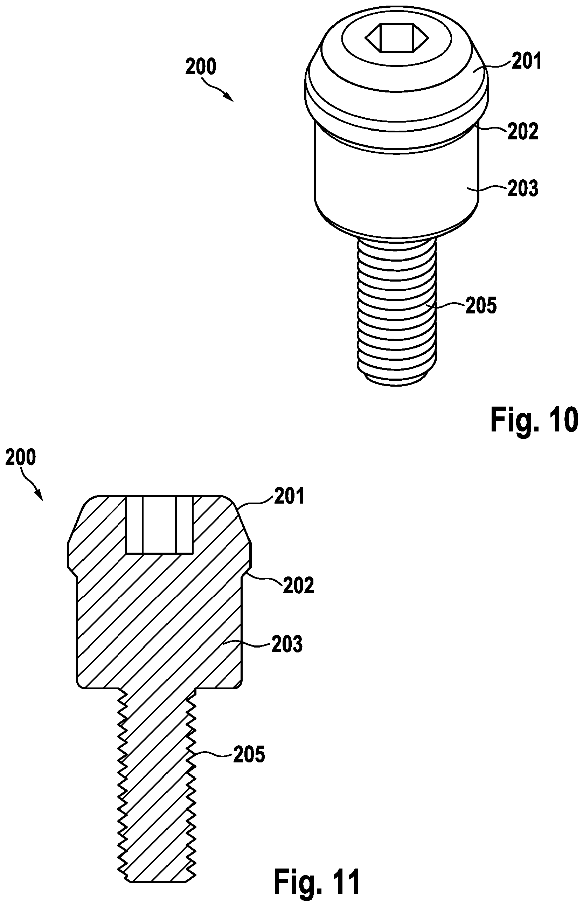

Die Figuren 10 und 11 zeigen eine weitere Ausführungsform eines Formschlussstücks 200, welches abweichend von dem in den Figuren 8 und 9 gezeigten Formschlussstück 200 insbesondere einteilig ausgebildet ist. Wie auch bei dem in den Figuren 8 und 9 gezeigten Formschlussstück 200 ist das freie Ende 201 mit einer Anlaufkontur versehen, welche das Zuschwenken der Schaltschranktür in die Schließposition erleichtern soll, wenn beispielsweise aufgrund von Fertigungstoleranzen die Formschlussaufnahme an der Türinnenseite und das Formschlussstück 200 bei ihrem Aufeinandertreffen nicht exakt miteinander fluchten. Das freie Ende 201 geht wiederum über einen Hinterschnitt 202 in einen schaftförmigen Abschnitt 203 über. Konzentrisch zu dem schaftförmigen Abschnitt 203 ist ein Gewindebolzen 205 an eine Auflageseite des Schafts 203 angeformt, über den das Formschlussstück 200 an einem Rahmengestell zur Anlage gebracht werden kann.

### Bezugszeichenliste:

- 100: Schaltschrank
- 101: Rahmengestell
- 102: Türseite
- 103: Scharnier
- 104: Schaltschranktür
- 105: Formschlussaufnahme
- 106: U-Umkantung
- 107: Auflage
- 108: Profilrahmen
- 109: Bodenrahmen
- 110: Horizontalstrebe
- 111: Haltewinkel
- 112: Befestigungsflansch
- 113: Aufstandsflansch
- 200: Formschlussstück
- 201: freies Ende
- 202: Hinterschnitt
- 203: Schaft
- 204: Korpus
- 205: Befestigungsmittel
- 206: Durchgangsbohrung
- 207: Vorsprung
- 300: Gleitboard
- 400: Transportpalette
- 401: Einfassung
- 500: Gabelstapler
- 600: Verpackung
- h: Höhe

## Patentansprüche

1. Stabilisierungsanordnung für den Transport eines Schaltschranks (100), mit einem Schaltschrank (100), der ein Rahmengestell (101) aus Vertikal- und Horizontalstreben aufweist, und mit einer an einer Türseite (102) des Rahmengestells (101) über mindestens ein Scharnier (103) befestigten Schaltschranktür (104), so dass die Schaltschranktür (104) zwischen einer Offenposition, in der sie von der Türseite (102) abgeschwenkt ist, und einer Schließposition, in der sie an der Türseite (102) anliegt, hin und her schwenkbar ist, wobei an der Türseite (102) mindestens ein Formschlussstück (200) befestigt ist, das sich mit seinem freien Ende (201) von der Türseite (102) weg erstreckt und an seinem freien Ende (201) einen Hinterschnitt (202) aufweist, wobei die Schaltschranktür (104) eine Formschlussaufnahme (105) aufweist, in die in der Schließstellung das Formschlussstück (200) mit seinem freien Ende (201) hinein ragt und die von dem Hinterschnitt (202) in der Schließstellung hintergriffen ist, und wobei das mindestens eine Formschlussstück (200) lösbar an der Türseite (102) befestigt ist und derart ausgestaltet ist, dass es nach dem Transport, das heißt nachdem der Schaltschrank (100) seine endgültige Position erreicht hat, wieder entfernt wird.

2. Stabilisierungsanordnung nach Anspruch 1, bei der das freie Ende (201) in Richtung senkrecht zur Erstreckungsrichtung des Formschlussstücks (200) eine maximale Abmessung aufweist, die einer Innenabmessung der Formschlussaufnahme (105) entspricht.

3. Stabilisierungsanordnung nach Anspruch 1 oder 2, bei der das freie Ende (201) in Erstreckungsrichtung des Formschlussstücks (200) an dem Hinterschnitt (202) in einen Schaft (203) des Formschlussstücks (200) übergeht, über den das Formschlussstück (200) an der Türseite (102) festgelegt ist.

4. Stabilisierungsanordnung nach Anspruch 3, bei der der Schaft (203) in Richtung senkrecht zur Erstreckungsrichtung des Formschlussstücks (200) eine maximale Abmessung aufweist, die kleiner als eine Innenabmessung der Formschlussaufnahme (105) ist.

5. Stabilisierungsanordnung nach einem der vorangegangenen Ansprüche, bei der die Formschlussaufnahme (105) ein Durchbruch in einer U-Umkantung (106) am Außenumfang der Schaltschranktür (104) ist.

6. Stabilisierungsanordnung nach einem der vorangegangenen Ansprüche, bei der das Formschlussstück (200) einen Korpus (204), der das freie Ende (201) und einen daran über den Hinterschnitt (202) am Außenumfang des Formschlussstücks (200) angrenzenden Schaft (203) aufweist, über den das Formschlussstück (200) an die Türseite (102) angrenzt, und ein Befestigungsmittel (205) aufweist, das den Korpus (204) an der Türseite (102) unbeweglich festlegt.

7. Stabilisierungsanordnung nach Anspruch 6, bei der der Korpus (204) und das Befestigungsmittel (205) als separate Bauteile ausgebildet sind und der Korpus (204) eine Durchgangsbohrung (206) aufweist, über die der Korpus (204) mit dem Befestigungsmittel (205), insbesondere einem Schraubbolzen, an der Türseite (102) festgelegt ist.

8. Stabilisierungsanordnung nach Anspruch 7, bei der der sich die Durchgangsbohrung (206) exzentrisch und parallel zu einer Symmetrieachse des Korpus (204) durch den Korpus (204) erstreckt, wobei der Schaft (203) an seinem der Türseite (102) zugewandten Ende einen Vorsprung (207) aufweist, der ebenfalls exzentrisch zu der Symmetrieachse des Korpus (204), jedoch in Bezug auf die Symmetrieachse gegenüber der Durchgangsbohrung (206) angeordnet ist, und wobei der Schaft (203) mit dem Vorsprung (207) auf einer horizontalen Auflage (107) des Rahmengestells (101) aufliegt.

9. Stabilisierungsanordnung nach Anspruch 6, bei der der Korpus (204) und das Befestigungsmittel (205) einteilig ausgebildet sind, wobei sich das Befestigungsmittel (205), insbesondere ein Schraubbolzen, konzentrisch zu dem Schaft (203) erstreckt und an ein der Türseite (102) zugewandtes Ende des Schafts (203) angeformt ist.

10. Stabilisierungsanordnung nach einem der vorangegangenen Ansprüche, bei der die Türseite (102) einen rechteckigen Profilrahmen (108) aufweist, wobei an dem Profilrahmen (108) zwei der Formschlussstücke (200) diametral gegenüber liegend angeordnet sind.

11. Stabilisierungsanordnung nach Anspruch 10, bei der an dem Profilrahmen (108) zwei Paare Formschlussstücke (200) angeordnet sind, von denen die beiden Formschlussstücke (200) eines ersten der Paare und die beiden Formschlussstücke (200) eines zweiten der Paare jeweils diametral gegenüber liegend, insbesondere in diametral gegenüber liegenden Eckbereichen des Profilrahmens (108), angeordnet sind.

12. Stabilisierungsanordnung nach einem der vorangegangenen Ansprüche, bei der das Rahmengestell (101) einen rechteckigen Bodenrahmen (109) aus vier Horizontalstreben aufweist, von denen eine Horizontalstrebe (110) in der Türseite (102) liegt und an dieser Horizontalstrebe (110) mindestens ein Haltewinkel (111) über einen Befestigungsflansch (112) des Haltewinkels (111) montiert ist, der in der Türseite (102) liegt, wobei an dem Befestigungsflansch (112) das mindestens eine Formschlussstück (200) und vorzugsweise der Befestigungsflansch (112) über einen Gewindebolzen des Formschlussstücks (200) an der Horizontalstrebe (110) festgelegt sind.

13. Stabilisierungsanordnung nach Anspruch 12, wobei die Stabilisierungsanordnung weiterhin mindestens ein Gleitboard (300) und eine Transportpalette (400) aufweist, und bei der der Schaltschrank (100) über den mindestens einen Haltewinkel (111) an dem mindestens einen Gleitboard (300) unterhalb des Bodenrahmens (109) befestigt ist, wobei der Bodenrahmen (109) über den mindestens einen Haltwinkel (111) unter einem Abstand zu dem mindestens einen Gleitboard (300) auf der mit einem Gabelstapler (500) unterfahrbaren Transportpalette (400) aufsteht.

14. Stabilisierungsanordnung nach Anspruch 13, bei der der Bodenrahmen (109) an jeder seiner vier Ecken einen als L-Winkel ausgebildeten Haltewinkel (111) aufweist, über den der Schaltschrank (100) an einem Gleitboard (300) befestigt ist, wobei der Abstand, unter dem der Bodenrahmen (109) zu dem mindestens einen Gleitboard (300) an dem Gleitboard (300) befestigt ist, einer vertikalen Abmessung eines Schaltschranksockels entspricht, und wobei die Haltewinkel (111) an einer Vertikalseite des Bodenrahmens (109) und sich mit ihrem Aufstandsflansch (113) von dem Schaltschrank (100) weg erstreckend befestigt sind, so dass eine Aufstandsseite des Bodenrahmens (109) für die Montage eines Schaltschranksockels an der Aufstandsseite vollständig frei liegt.

15. Stabilisierungsanordnung nach Anspruch 13 oder 14, bei der die Transportpalette (400) eine Einfassung (401) aufweist, die das mindestens eine Gleitboard (300) umrandet, so dass der Schaltschrank (100) auf der Transportpalette (400) in Horizontalrichtung unverrückbar ist.

## Claims

1. A stabilizing arrangement for transporting a switch cabinet (100), comprising a switch cabinet (100) having a frame (101) of vertical and horizontal struts, and a switch cabinet door (104) attached to a door side (102) of the frame (101) via at least one hinge (103), so that the switch cabinet door (104) can be pivoted back and forth between an open position, in which it is pivoted away from the door side (102), and a closed position, in which it rests against the door side (102), at least one form-fitting piece (200) being fastened to the door side (102) which extends with its free end (201) away from the door side (102) and has an undercut (202) at its free end (201), the switch cabinet door (104) having a form-fitting receptacle (105) into which the form-fitting piece (200) projects with its free end (201) in the closed position and which is engaged behind by the undercut (202) in the closed position and wherein the at least one form-fitting piece (200) is detachably fastened to the door side (102) and is configured in such a way that it is removed again after transport, that is to say after the switch cabinet (100) has reached its final position.

2. The stabilizing arrangement of claim 1, wherein the free end (201) has a maximum dimension in a direction perpendicular to the direction of extension of the form-fitting piece (200) that corresponds to an inner dimension of the form-fitting receptacle (105).

3. The stabilizing arrangement according to claim 1 or 2, in which the free end (201) in the direction of extension of the form-fitting piece (200) at the undercut (202) merges into a shank (203) of the form-fitting piece (200), via which the form-fitting piece (200) is fixed to the door side (102).

4. The stabilizing arrangement of claim 3, wherein the shaft (203) has a maximum dimension in a direction perpendicular to the direction of extension of the form-fitting (200) that is less than an inner dimension of the form-fitting receptacle (105).

5. The stabilizing arrangement according to any one of the preceding claims, wherein the form-fit receptacle (105) is an aperture in a U-bend (106) on the outer periphery of the enclosure door (104).

6. The stabilizing arrangement according to any one of the preceding claims, wherein the form-fitting (200) comprises a body (204) having the free end (201) and a shank (203) adjacent thereto via the undercut (202) on the outer periphery of the form-fitting (200), via which shank the form-fitting (200) abuts the door face (102), and a fixing means (205) immovably fixing the body (204) to the door face (102).

7. The stabilizing arrangement according to claim 6, wherein the body (204) and the fastening means (205) are formed as separate components and the body (204) comprises a through hole (206) via which the body (204) is fixed to the door side (102) by the fastening means (205), in particular a screw bolt.

8. The stabilizing arrangement of claim 7, wherein the through bore (206) extends through the body (204) eccentrically and parallel to an axis of symmetry of the body (204), the shaft (203) having a projection (207) at its end facing the door side (102), which is likewise arranged eccentrically to the axis of symmetry of the body (204), but opposite the through-bore (206) with respect to the axis of symmetry, and wherein the shaft (203) rests with the projection (207) on a horizontal support (107) of the frame (101).

9. The stabilizing arrangement according to claim 6, wherein the body (204) and the fastening means (205) are integrally formed, the fastening means (205), in particular a screw bolt, extending concentrically to the shaft (203) and being formed on an end of the shaft (203) facing the door side (102).

10. The stabilizing arrangement according to any one of the preceding claims, wherein the door side (102) comprises a rectangular profile frame (108), wherein two of the positive locking pieces (200) are arranged diametrically opposite each other on the profile frame (108).

11. The stabilizing arrangement according to claim 10, wherein two pairs of form-fitting pieces (200) are arranged on the profile frame (108), of which the two form-fitting pieces (200) of a first one of the pairs and the two form-fitting pieces (200) of a second one of the pairs are each arranged diametrically opposite one another, in particular in diametrically opposite corner regions of the profile frame (108).

12. The stabilizing arrangement according to any one of the preceding claims, wherein the framework (101) comprises a rectangular floor frame (109) of four horizontal struts, of which one horizontal strut (110) lies in the door side (102) and to this horizontal strut (110) at least one mounting bracket (111) is mounted via a mounting flange (112) of the mounting bracket (111), which lies in the door side (102), the at least one form-fitting piece (200) being fixed to the fixing flange (112) and preferably the fixing flange (112) being fixed to the horizontal strut (110) via a threaded bolt of the form-fitting piece (200).

13. The stabilizing arrangement according to claim 12, wherein the stabilizing arrangement further comprises at least one sliding board (300) and a transport pallet (400), and wherein the switch cabinet (100) is attached to the at least one sliding board (300) below the floor frame (109) via the at least one retaining angle (111), wherein the floor frame (109) stands up on the transport pallet (400), which can be driven under by a forklift truck (500), at a distance from the at least one sliding board (300) via the at least one retaining angle (111).

14. The stabilizing arrangement of claim 13, wherein the base frame (109) has at each of its four corners a retaining bracket (111) formed as an L-bracket, by means of which the switch cabinet (100) is attached to a sliding board (300), wherein the distance at which the base frame (109) is attached to the at least one sliding board (300) to the sliding board (300), corresponds to a vertical dimension of a switch cabinet base, and wherein the retaining brackets (111) are secured to a vertical side of the base frame (109) and extending away from the switch cabinet (100) with their support flange (113), so that a support side of the base frame (109) is completely exposed for the mounting of a switch cabinet base on the support side.

15. The stabilizing arrangement according to claim 13 or 14, wherein the transport pallet (400) comprises an enclosure (401) that surrounds the at least one sliding board (300) so that the switch cabinet (100) is immovable on the transport pallet (400) in the horizontal direction.

## Revendications

1. Dispositif de stabilisation pour le transport d'une armoire de commande (100), avec une armoire de commande (100), qui comprend un châssis (101) constitué de montants verticaux et horizontaux, et avec une porte d'armoire de commande (104) fixée à un côté de porte (102) du châssis (101) par l'intermédiaire d'au moins une charnière (103), de façon à ce que la porte d'armoire de commande (104) puisse être pivotée avec un mouvement de va-et-vient entre une position ouverte, dans lequel elle est pivotée loin du côté de porte (102) et une position de fermeture, dans laquelle elle s'appuie contre le côté de porte (102), dans lequel, sur le côté de porte (102), est fixée au moins une pièce de complémentarité de forme (200) qui s'éloigne, avec son extrémité libre (201), du côté de porte (102) et qui présente, à son extrémité libre (201), une contre-dépouille (202), dans lequel la porte d'armoire de commande (104) présente un logement de complémentarité de forme (105) dans laquelle, dans la position de fermeture, la pièce de complémentarité de forme (200) dépasse avec son extrémité libre (201) et qui est accroché par l'arrière, dans la position de fermeture, par la contre-dépouille (202) et dans lequel l'au moins une pièce de complémentarité de forme (200) est fixée de manière amovible au côté de porte (102) et est conçue de façon à ce que, après le transport, c'est-à-dire après que l'armoire de commande (100) ait atteint sa position définitive, elle soit retirée.

2. Dispositif de stabilisation selon la revendication 1, dans lequel l'extrémité libre (201) présente, dans une direction perpendiculaire à la direction d'extension de la pièce de complémentarité de forme (200), une dimension maximale qui correspond à une dimension interne du logement de complémentarité de forme (105).

3. Dispositif de stabilisation selon la revendication 1 ou 2, dans lequel l'extrémité libre (201) se transforme, dans la direction d'extension de la pièce de complémentarité de forme (200), au niveau de la contre-dépouille (202), en une tige (203) de la pièce de complémentarité de forme (200), par l'intermédiaire de laquelle la pièce de complémentarité de forme (200) est fixée au côté de porte (102).

4. Dispositif de stabilisation selon la revendication 3, dans lequel la tige (203) présente, dans une direction perpendiculaire à la direction d'extension de la pièce de complémentarité de forme (200), une dimension maximale qui est inférieure à une dimension interne du logement de complémentarité de forme (105).

5. Dispositif de stabilisation selon l'une des revendications précédentes, dans lequel le logement de complémentarité de forme (105) est une percée dans un pilage en U (106) sur la circonférence externe de la porte d'armoire de commande (104).

6. Dispositif de stabilisation selon l'une des revendications précédentes, dans lequel la pièce de complémentarité de forme (200) comprend un corps (204) qui comprend l'extrémité libre (201) et une tige (203) qui jouxte celle-ci par l'intermédiaire de la contre-dépouille (202) sur la circonférence externe de la pièce de complémentarité de forme (200), par l'intermédiaire duquel la pièce de complémentarité de forme (200) jouxte le côté de porte (102) et un moyen de fixation (205) qui fixe le corps (204) au côté de porte (102) de manière immobile.

7. Dispositif de stabilisation selon la revendication 6, dans lequel le corps (204) et le moyen de fixation (205) sont conçus comme des pièces séparées et le corps (204) comprend un trou de passage (206) par l'intermédiaire duquel le corps (204) est fixé avec le moyen de fixation (205), plus particulièrement une tige filetée, au côté de porte (102).

8. Dispositif de stabilisation selon la revendication 7, dans lequel le trou de passage (206) s'étend de manière excentrique et parallèle à un axe de symétrie du corps (204) à travers le corps (204), dans lequel la tige (203) comprend, à son extrémité orientée vers le côté de porte (102), une saillie (207) qui est également disposée de manière excentrique par rapport à l'axe de symétrie du corps (204), mais par rapport à l'axe de symétrie en face du trou de passage (206) et dans lequel la tige (203) repose, avec la saillie (207), sur un appui horizontal (107) du châssis (101).

9. Dispositif de stabilisation selon la revendication 6, dans lequel le corps (204) et le moyen de fixation (205) sont conçus d'une seule pièce, dans lequel le moyen de fixation (205), plus particulièrement une tige filetée, s'étend de manière concentrique par rapport à la tige (203) et est moulé sur une extrémité de la tige (203) orientée vers le côté de porte (102).

10. Dispositif de stabilisation selon l'une des revendications précédentes, dans lequel le côté de porte (102) comprend un cadre profilé rectangulaire (108), dans lequel, sur le cadre profilé (108) sont disposées deux des pièces de complémentarité de forme (200), de manière diamétralement opposée.

11. Dispositif de stabilisation selon la revendication 10, dans lequel, sur le cadre profilé (108), sont disposées deux paires de pièces de complémentarité de forme (200), dont les deux pièces de complémentarité de forme (200) d'une première des paires et les deux pièces de complémentarité de forme (200) d'une deuxièmement des paires sont disposées de manière diamétralement opposée, plus particulièrement dans des zones angulaires diamétralement opposées du cadre profilé (108).

12. Dispositif de stabilisation selon l'une des revendications précédentes, dans lequel le châssis (101) comprend un cadre de fond rctangulaire (109) constitué de quatre montants horizontaux, dont un montant horizontal (110) se trouve dans le côté de porte (102) et, sur ce montant horizontal (110), est monté au moins un angle de maintien (111) par l'intermédiaire d'une bride de fixation (112) de l'angle de maintien (111), qui se trouve dans le côté de porte (102), dans lequel, sur la bride de fixation (112), l'au moins une pièce de complémentarité de forme (200) et de préférence la bride de fixation (112) sont fixées par l'intermédiaire d'une tige filetée de la pièce de complémentarité de forme (200) au montant horizontal (110).

13. Dispositif de stabilisation selon la revendication 12, dans lequel le dispositif de stabilisation comprend en outre au moins une planche de glissement (300) et une palette de transport (400) et dans lequel l'armoire de commande (100) est fixée par l'intermédiaire de l'au moins un angle de maintien (111) à l'au moins un panneau coulissant (300) en dessous du cadre de fond (109), dans lequel le cadre de fond (109) est posé, par l'intermédiaire d'au moins un angle de maintien (111), à une distance de l'au moins une planche de glissement (300), sur la palette de transport (400) pouvant être prise par en dessous avec un chariot élévateur (500).

14. Dispositif de stabilisation selon la revendication 13, dans lequel le cadre de fond (109) comprend, à chacun de ses quatre coins, un angle de maintien (111) conçu comme un angle en L, par l'intermédiaire duquel l'armoire de commande (100) est fixée à une planche de glissement (300), dans lequel la distance par rapport à l'au moins une planche de glissement (300) à laquelle le cadre de fond (109) est fixé à la planche de glissement (300), correspond à une dimension verticale d'un socle d'armoire de commande et dans lequel les angles de maintien (111) sont fixés à un côté vertical du cadre de fond (109) et de façon à s'éloigner, avec leur bride de support (113), de l'armoire de commande (100), de façon à ce qu'un côté de support du cadre de fond (109) soit entièrement libre pour le montage d'un socle d'armoire de commande sur le côté de support.

15. Dispositif de stabilisation selon la revendication 13 ou 14, dans lequel la palette de transport (400) comprend une bordure (401) qui entoure l'au moins une planche de glissement (300), de façon à ce que l'armoire de commande (100) soit immobilisée dans la direction horizontale sur la palette de transport (400).
